(19) Europäisches Patentamt
European Patent Office
Office européen des brevets

(11) **EP 4 669 038 A1**

(12) **EUROPEAN PATENT APPLICATION**
published in accordance with Art. 153(4) EPC

(43) Date of publication:
**24.12.2025 Bulletin 2025/52**

(21) Application number: **23927151.3**

(22) Date of filing: **20.11.2023**

(51) International Patent Classification (IPC):
***H05K 5/02*** *(2006.01)*

(52) Cooperative Patent Classification (CPC):
**G09F 9/30; H05K 5/02**

(86) International application number:
**PCT/CN2023/132665**

(87) International publication number:
**WO 2024/187810 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.03.2023 CN 202310278159**

(71) Applicant: **Honor Device Co., Ltd.
Shenzhen, Guangdong 518040 (CN)**

(72) Inventors:
• **MIAO, Dengkui
Shenzhen, Guangdong 518040 (CN)**
• **XU, Wenbin
Shenzhen, Guangdong 518040 (CN)**
• **WANG, Wei
Shenzhen, Guangdong 518040 (CN)**
• **LAI, Shunqi
Shenzhen, Guangdong 518040 (CN)**

(74) Representative: **Thun, Clemens
Mitscherlich PartmbB
Patent- und Rechtsanwälte
Karlstraße 7
80333 München (DE)**

(54) **SHELL STRUCTURE, DISPLAY MODULE, AND ELECTRONIC DEVICE**

(57) Embodiments of this application provide a housing structure, a display module, and an electronic device, and relate to the technical field of electronic devices. The housing structure can improve scratch resistance of cover plate glass. When the housing structure is applied to a 3D curved display panel, there is no appearance color difference in a 3D cambered display area, so that the electronic device has a good appearance. The housing structure includes a substrate and a scratch-resistant layer located on a side of the substrate. The scratch-resistant layer includes at least two materials, and the at least two materials include at least one high refractive index material and at least one low refractive index material. The scratch-resistant layer has a thickness greater than or equal to 300 nm and less than or equal to 5000 nm. The low refractive index material has a refractive index less than or equal to a refractive index of the substrate, and the high refractive index material has a refractive index greater than 1.6.

FIG. 10

EP 4 669 038 A1

## Description

This application claims priority to Chinese Patent Application No. 202310278159.9, filed with the China National Intellectual Property Administration on March 15, 2023 and entitled "HOUSING STRUCTURE, DISPLAY MODULE, AND ELECTRONIC DEVICE", which is incorporated herein by reference in its entirety.

## TECHNICAL FIELD

This application relates to the technical field of electronic devices, and in particular, to a housing structure, a display module, and an electronic device.

## BACKGROUND

A display panel is a component of an electronic device such as a mobile phone or a Slate, which implements a display function. To enhance a mechanical strength and wear resistance of the display panel, an outer side of the display panel is usually covered with a glass cover plate having a protective function.

However, with the use of the electronic device such as the mobile phone or the Slate, contact between the glass cover plate and a hard object leads to more and more visible scratches on a surface of the glass cover plate, which affects aesthetics of the electronic device. The scratches may further destroy stress balance of cover plate glass, resulting in decrease of impact resistance of the glass cover plate.

## SUMMARY

To solve the foregoing technical problems, this application provides a housing structure, a display module, and an electronic device. This can improve scratch resistance of cover plate glass. When the housing structure is applied to a 3D curved display panel, there is no appearance color difference in a 3D cambered display area, so that the electronic device has a good appearance.

According to a first aspect, an embodiment of this application provides a housing structure, including a substrate and a scratch-resistant layer located on a side of the substrate. The scratch-resistant layer includes at least two materials, and the at least two materials include at least one high refractive index material and at least one low refractive index material. The scratch-resistant layer has a thickness greater than or equal to 300 nm and less than or equal to 5000 nm. The low refractive index material has a refractive index less than or equal to a refractive index of the substrate, and the high refractive index material has a refractive index greater than 1.6.

The at least one high refractive index material and the at least one low refractive index material are mixed to form the scratch-resistant layer, so that a refractive index of the scratch-resistant layer is the same as or close to that of the substrate. In this way, a protective structure has no impact on a light transmittance and a light reflectance of the substrate, thereby avoiding an impact of a small thickness of an edge area of the protective structure on the appearance color. In addition, since the scratch-resistant layer includes the high refractive index material, and the high refractive index material is dense and has a thickness ranging from 300 nm to 5000 nm, the scratch-resistant layer has high scratch resistance. To sum up, the housing structure according to the embodiment of this application has a good appearance and optical performance, and has high scratch resistance.

According to the first aspect, the housing structure further includes a first underlayer located between the substrate and the scratch-resistant layer, and configured to improve adhesion between the substrate and the scratch-resistant layer, so as to prevent a film layer from falling off to cause a poor appearance, and improve a yield of a hard coating section.

According to the first aspect, or any one of the above implementations of the first aspect, a material of the first underlayer is the same as a material element of the substrate, or is in the same family as or adjacent to the material element of the substrate (in a periodic table of elements).

For example, when the substrate is made of inorganic glass, since the inorganic glass contains silicon dioxide, the material of the first underlayer is, for example, silicon dioxide. When the substrate is made of sapphire, since the sapphire contains aluminum oxide, the material of the first underlayer is, for example, aluminum oxide. In this way, the substrate and the first underlayer can be better combined.

According to the first aspect, or any one of the above implementations of the first aspect, the first underlayer has a thickness greater than or equal to 5 nm and less than or equal to 200 nm. In this way, it is prevented that the adhesion between the substrate and the scratch-resistant layer is not increased because of a too small thickness of the first underlayer, and that the first underlayer shows its own performance because of a too large thickness of the first underlayer.

According to the first aspect, or any one of the above implementations of the first aspect, the housing structure further includes an optical adjustment layer located on a side of the scratch-resistant layer that faces away from the substrate, and configured to adjust an appearance color of the housing structure, so that optical performance of that substrate is modified to meet optical performance requirements.

According to the first aspect, or any one of the above implementations of the first aspect, the optical adjustment layer has a thickness less than or equal to 300 nm. In some embodiments, the optical adjustment layer has a thickness greater than or equal to 60 nm and less than or equal to 80 nm. For example, a thickness H3 of the optical adjustment layer is 60 nm, 65 nm, 70 nm, 75 nm, or 80 nm.

According to the first aspect, or any one of the above implementations of the first aspect, a material of the optical adjustment layer includes at least one of silicon dioxide, titanium dioxide, tantalum pentoxide, niobium pentoxide, and the like. The material of the optical adjustment layer is not limited in the embodiment of this application, and may be chosen by a person skilled in the art based on an actual need.

For example, the material of the optical adjustment layer includes one of silicon dioxide, titanium dioxide, tantalum pentoxide, niobium pentoxide, and the like, or the material of the optical adjustment layer includes at least two of silicon dioxide, titanium dioxide, tantalum pentoxide, niobium pentoxide, and the like.

According to the first aspect, or any one of the above implementations of the first aspect, the housing structure further includes an antifriction layer located on a side of the scratch-resistant layer that faces away from the substrate. The antifriction layer has an anti-fingerprint (Anti-fingerprint, AF) function, and when a user touches the display module, the display module has a smooth touch, which is beneficial to user experience.

According to the first aspect, or any one of the above implementations of the first aspect, the antifriction layer has a dynamic friction coefficient greater than or equal to 0.01 and less than or equal to 0.1, and a contact angle greater than 100°. In this way, there is a small frictional force between a finger and the housing structure, which reduces damage to each film layer of the housing structure.

According to the first aspect, or any one of the above implementations of the first aspect, the antifriction layer has a thickness greater than or equal to 3 nm and less than or equal to 50 nm.

For example, the thickness of the antifriction layer includes 5 nm, 10 nm, 15 nm, 20 nm, 25 nm, 30 nm, 35 nm, 40 nm, 45 nm, or 50 nm.

According to the first aspect, or any one of the above implementations of the first aspect, the antifriction layer is composed of an organic material and an inorganic material that have low surface energy.

For example, a material of the antifriction layer includes perfluoropolyethers (Perfluoropolyethers, PFPE).

According to the first aspect, or any one of the above implementations of the first aspect, the housing structure further includes a second underlayer located between the antifriction layer and the scratch-resistant layer, and configured to improve adhesion of the antifriction layer, so as to prevent a film layer from falling off to cause a poor appearance, and improve a yield of a hard coating section.

According to the first aspect, or any one of the above implementations of the first aspect, the second underlayer includes a first sub-underlayer and a second sub-underlayer, and the second sub-underlayer is located on a side of the first sub-underlayer that faces away from the scratch-resistant layer. Of course, the second underlayer may alternatively include only one film layer, or the like.

According to the first aspect, or any one of the above implementations of the first aspect, the first sub-underlayer has a thickness less than or equal to 200 nm; and the second sub-underlayer has a thickness less than or equal to 50 nm.

In this way, it is prevented that the adhesion between the substrate and the scratch-resistant layer is not increased because of a too small thickness of the second underlayer, and that the second underlayer shows its own performance because of a too large thickness of the second underlayer.

According to the first aspect, or any one of the above implementations of the first aspect, a material of the second sub-underlayer includes silicon monoxide, silicon dioxide, a material doped with silicon dioxide, or the like; and a material of the first sub-underlayer includes diamond-like carbon, diamond, carbon nitride, or the like. The materials of the first sub-underlayer and the second sub-underlayer are not limited in the embodiment of this application, and may be chosen by a person skilled in the art based on an actual need.

According to the first aspect, or any one of the above implementations of the first aspect, the refractive index of the scratch-resistant layer satisfies the following formulas:

$$R0 \leq 100\% - R1 - T1,$$

and

$$R0 = \left[ \frac{n0 - n1^2/n2}{n0 + n1^2/n2} \right]^2,$$

where R0 is a reflectivity of the scratch-resistant layer; R1 is a reflectivity of the substrate; T1 is a transmittance of the housing structure; n0 is a refractive index 1 of air; n1 is the refractive index of the scratch-resistant layer; and n2 is a refractive index of the substrate.

In this way, it can be ensured that the transmittance of the housing structure is a preset value (a required transmittance, for example, 90.5% or above) or above, so that the film layer has no impact on the light transmittance and the light reflectance of the substrate.

According to the first aspect, or any one of the above implementations of the first aspect, mass fractions of the high refractive index material and the low refractive index material satisfy:

$$ n1^2 = \sum_{i=1}^{N} \left( \frac{a_i n_i^2 c_i}{\rho_i} \right) \Big/ \sum_{i=1}^{N} \left( \frac{a_i c_i}{\rho_i} \right), $$

where $a_i = (n_i^2 + 2)^{-1}$, $\rho_i$ is a material density, $C_i$ is a material mass fraction, and $n_i$ is a material refractive index.

A scratch-resistant layer with a refractive index being, for example, 1.56 or below can be obtained by mixing the high refractive index material and the low refractive index material with mass proportions obtained based on the formula, so that the scratch-resistant layer has no impact on the light transmittance and light reflectance of the substrate.

According to the first aspect, or any one of the above implementations of the first aspect, the scratch-resistant layer is formed by mixing aluminum oxide and silicon dioxide, the aluminum oxide has a mass fraction less than or equal to 80%, and the scratch-resistant layer has a refractive index less than or equal to 1.7.

According to the first aspect, or any one of the above implementations of the first aspect, the scratch-resistant layer is formed by mixing silicon nitride and silicon dioxide, the silicon nitride has a mass fraction less than or equal to 60%, and the scratch-resistant layer has a refractive index less than or equal to 1.7.

According to the first aspect, or any one of the above implementations of the first aspect, each of the above-mentioned film layers is formed by a deposition process. For example, the scratch-resistant layer is formed by the deposition process. Even if the scratch-resistant layer formed through coating by the deposition process have different thicknesses at a large surface and a 3D cambered surface, there is no problem of inconsistent appearance colors.

According to a second aspect, an embodiment of this application provides a display module, including the housing structure according to the first aspect and any one of the implementations of the first aspect, and the second aspect corresponds to the first aspect and any one of the implementations of the first aspect. For the technical effects corresponding to the second aspect, reference may be made to the technical effects corresponding to the first aspect and any one of the implementations of the first aspect. Details are not described herein.

According to a third aspect, an embodiment of this application provides an electronic device, including the housing structure according to the first aspect and any one of the implementations of the first aspect, and the third aspect corresponds to the first aspect and any one of the implementations of the first aspect. For the technical effects corresponding to the third aspect, reference may be made to the technical effects corresponding to the first aspect and any one of the implementations of the first aspect. Details are not described herein.

According to the third aspect, the electronic device includes a display module. The display module includes a display panel and a cover plate located on a side of the display panel, and the housing structure is the cover plate of the electronic device.

According to the third aspect, the electronic device includes a rear cover, and the housing structure is the rear cover of the electronic device. For example, the rear cover is a battery cover of a mobile phone or a Slate.

## BRIEF DESCRIPTION OF DRAWINGS

FIG. 1 is a schematic diagram of a structure of an electronic device according to an embodiment of this application;
FIG. 2 is an exploded view of the electronic device shown in FIG. 1;
FIG. 3 is a schematic diagram of a structure of another electronic device according to an embodiment of this application;
FIG. 4 is a schematic diagram of a structure of another electronic device according to an embodiment of this application;
FIG. 5 is a schematic diagram of a cross-sectional structure of a cover plate of the electronic device shown in FIG. 4 according to an embodiment of this application, which is taken along line AA';
FIG. 6 is a schematic diagram of a cross-sectional structure of another cover plate of the electronic device shown in FIG. 4 according to an embodiment of this application, which is taken along line AA';

FIG. 7 is a schematic diagram of a cross-sectional structure of a housing structure of the electronic device shown in FIG. 4 according to an embodiment of this application, which is taken along line AA';

FIG. 8 is a schematic diagram of optical reflection of a scratch-resistant layer;

FIG. 9 is a schematic diagram of a cross-sectional structure of another housing structure of the electronic device shown in FIG. 4 according to an embodiment of this application, which is taken along line AA';

FIG. 10 is a schematic diagram of a cross-sectional structure of another housing structure of the electronic device shown in FIG. 4 according to an embodiment of this application, which is taken along line AA';

FIG. 11 is a schematic diagram of a cross-sectional structure of another housing structure of the electronic device shown in FIG. 4 according to an embodiment of this application, which is taken along line AA';

FIG. 12 is a comparative test diagram of a housing structure according to an embodiment of this application;

FIG. 13 is a flowchart of a method for preparing a housing structure according to an embodiment of this application; and

FIG. 14 is a flowchart of another method for preparing a housing structure according to an embodiment of this application.

## DESCRIPTION OF EMBODIMENTS

The technical solutions in embodiments of this application are clearly and completely described below with reference to the accompanying drawings in the embodiments of this application. Apparently, the described embodiments are merely some rather than all of the embodiments of this application. All other embodiments obtained by a person of ordinary skill in the art based on the embodiments of this application without creative efforts should fall within the protection scope of this application.

The term "and/or" herein is merely a description of the associated relationship of associated objects, representing that three relationships may exist. For example, A and/or B may be expressed as the three instances: A exists alone, A and B coexist, or B exists alone.

The terms "first", "second", and the like in the specification of embodiments of this application and claims are used to distinguish between different objects, not to describe a specific order of objects. For example, a first target object, a second target object, and the like are used to distinguish between different target objects, not to describe a specific order of target objects.

In embodiments of this application, the word such as "example" or "for example" is used to represent giving an example, an illustration, or a description. In embodiments of this application, any embodiment or design solution described as "for example" or "such as" shall not be explained as being more preferred or advantageous than other embodiments or design solutions. To be specific, the use of the word such as "example" or "for example" is intended to present the related concepts in a specific manner.

In the description of embodiments of this application, unless otherwise stated, "a plurality of" refers to two or more. For example, a plurality of processing units refer to two or more processing units; and a plurality of systems refer to two or more systems.

An embodiment of this application provides an electronic device. The electronic device according to the embodiment of this application may be a mobile phone, a notebook computer, a tablet computer, a personal digital assistant (personal digital assistant, PDA), an in-vehicle computer, a television, a smart wearable device (such as a smartwatch, a smart bracelet, a smart head-mounted display, or smart glasses), a smart home device, or the like. A specific form of the electronic device is not particularly limited in the embodiment of this application. For ease of description, an example in which an electronic device is a mobile phone is used for description below.

To clearly describe subsequent structural features and a positional relationship of the structural features, a positional relationship of each structure in the mobile phone is specified in an X-axis direction, a Y-axis direction, and a Z-axis direction. The X-axis direction is a width direction of the mobile phone, the Y-axis direction is a length direction of the mobile phone, and the Z-axis direction is a thickness direction of the mobile phone.

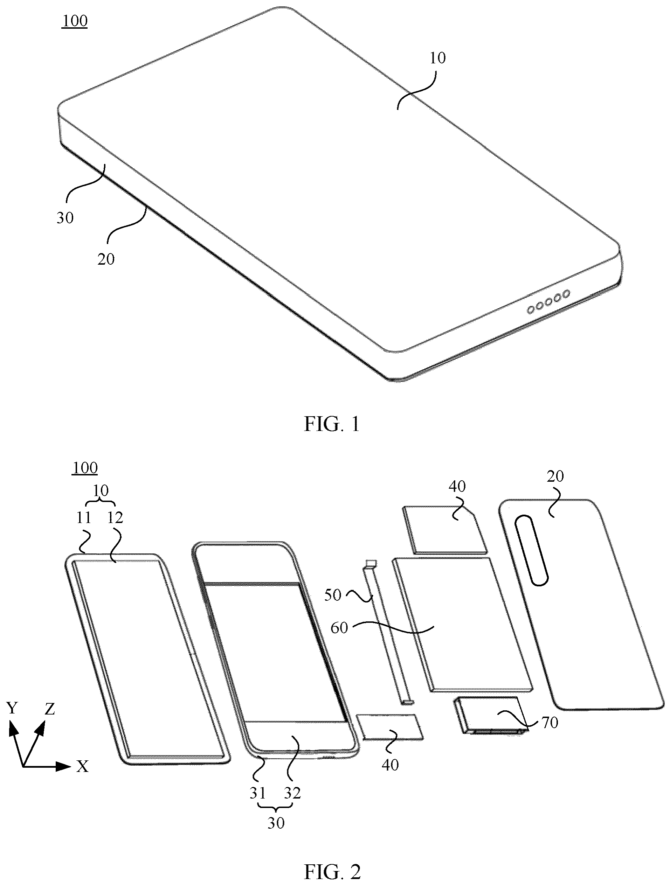

Refer to FIG. 1. FIG. 1 is a schematic diagram of a structure of an electronic device according to an embodiment of this application. As an example, the electronic device is a mobile phone. As shown in FIG. 1, a mobile phone 100 includes a display module 10, a rear cover (also referred to as a battery cover) 20, and a middle frame 30.

It can be understood that in FIG. 1, the mobile phone 100 is in a rectangular flat plate shape. In another optional embodiment, the electronic device may alternatively be in a square flat plate shape, a circular flat plate shape, an oval flat plate shape, or the like. Of course, the electronic device may alternatively be a foldable electronic device (such as a foldable mobile phone), or the like.

Refer to FIG. 2. FIG. 2 is an exploded view of the electronic device shown in FIG. 1. As shown in FIG. 2, in the Z-axis direction, the display module 10 includes a cover plate 11 and a display panel 12 that are stacked, and the cover plate 11 is attached to the display panel 12 through a transparent adhesive layer (not shown in the figure), for example. The transparent adhesive layer is, for example, an optically clear adhesive (optically clear adhesive, OCA). The display panel 12 includes, for example, an organic light emitting diode (Organic Light Emitting Diode, OLED) display panel, a liquid crystal display (Liquid Crystal Display, LCD) panel, or an LED display panel. The LED display panel includes, for example, a Micro-LED display panel or a Mini-LED display panel. The type of the display panel 12 is not particularly limited in the embodiment of this application.

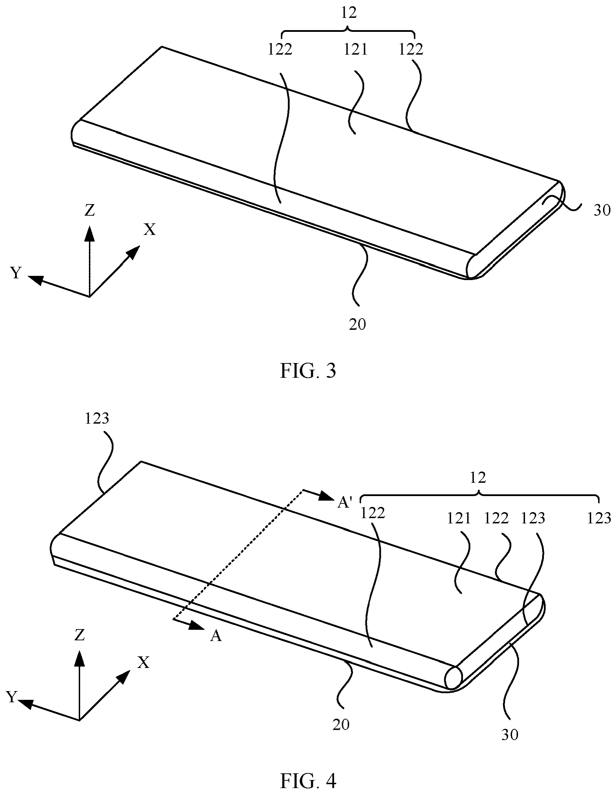

It should be noted that, the display panel 12 is not limited to a 2D (Dimensions, dimensions) display panel shown in FIG. 1 and FIG. 2, and may alternatively be a 2.5D curved display panel (not shown in the figure) or a 3D curved display panel (see FIG. 3). When being a 2.5D curved display panel or a 3D curved display panel, the display panel 12 may be a hyperbolic display panel or a four-sided curved display panel. Referring to FIG. 3, when the display panel 12 is a hyperbolic display panel, the display panel 12 includes not only a main display part 121, but also first arc-shaped display parts 122 located on two opposite sides of the main display part 121 in the X-axis direction. Referring to FIG. 4, when the display panel 12 is a four-sided curved display panel, the display panel 12 includes not only a main display part 121 and first arc-shaped display parts 122 located on two opposite sides of the main display part 121 in the X-axis direction, but also second arc-shaped display parts 123 located on the two opposite sides of the main display part 121 in the Y-axis direction.

It can be understood that to clearly show the structure of the display panel 12, the cover plate of the mobile phone 100 is not shown in either FIG. 3 or FIG. 4.

Correspondingly, when the display panel 12 is a 2.5D curved display panel or a 3D curved display panel, the cover plate 11 is also a 2.5D curved cover plate or a 3D curved cover plate. That is, the cover plate is conformal with the display panel. For example, corresponding to FIG. 3, when the display panel 12 includes a main display part 121 and two first arc-shaped display parts 122, the cover plate 11 includes a straight part opposite to the main display part 121 and two first curved parts opposite to the first arc-shaped display parts 122. Corresponding to FIG. 4, when the display panel 12 includes a main display part 121, two first arc-shaped display parts 122, and two second arc-shaped display parts 123, the cover plate 11 includes a straight part opposite to the main display part 121, two first curved parts opposite to the first arc-shaped display parts 122, and two second curved parts opposite to the second arc-shaped display parts 123.

It should be noted that, that the main display part 121 is opposite to the straight part may be that a projection of the main display part 121 on a plane composed of an X-axis and a Y-axis coincides with a projection of the straight part on the plane composed of the X-axis and the Y-axis. That the first arc-shaped display part 122 is opposite to the first curved part may be that a projection of the first arc-shaped display part 122 on the plane composed of the X-axis and the Y-axis coincides with a projection of the first curved part on the plane composed of the X-axis and the Y-axis, or the projection of the first arc-shaped display part 122 on the plane composed of the X-axis and the Y-axis is located in the projection of the first curved part on the plane composed of the X-axis and the Y-axis. That the second arc-shaped display part 123 is opposite to the second curved part may be that a projection of the second arc-shaped display part 123 on the plane composed of the X-axis and the Y-axis coincides with a projection of the second curved part on the plane composed of the X-axis and the Y-axis, or the projection of the second arc-shaped display part 123 on the plane composed of the X-axis and the Y-axis is located in the projection of the second curved part on the plane composed of the X-axis and the Y-axis.

The following examples are all explained by taking the display panel 10 as a 3D curved display panel and the cover plate 11 as a 3D curved cover plate.

Still referring to FIG. 1 and FIG. 2, the rear cover 20 is located on a side of the display panel 12 that faces away from the cover plate 11. A material of the rear cover 20 may include, for example, an opaque material such as plastic, vegan leather, or glass fiber, or may include a transparent material such as glass. The material of the rear cover 20 is not limited in the embodiment of this application.

The middle frame 30 is located between the cover plate 11 and the rear cover 20. The middle frame 30 includes an annular exterior part 31 and a support member 32 located in the annular exterior part 31 and between the display panel 12 and the rear cover 20. The cover plate 11, the annular exterior part 31, and the rear cover 20 can define an accommodating cavity. The display panel 12, a printed circuit board (Printed Circuit Board, PCB) 40, a flexible printed circuit (Flexible Printed Circuit, FPC) 50, a battery 60, a speaker module 70, a system on chip (System on Chip, SoC) arranged on the PCB 40, an application processor (Application Processor, AP) and other structures (not shown in the figure) are arranged in the accommodating cavity, and the structures in the accommodating cavity are supported by the support member 32 of the middle frame 30. For example, the display module 10 is arranged on the support member 32 by, for example, a back adhesive, and the display module 10 is supported by the support member 32.

The cover plate 11 is, for example, a glass substrate. Although the glass substrate can enhance a mechanical strength and wear resistance of the display panel 12, with the use of the electronic device such as the mobile phone or the Slate, contact between the glass substrate and a hard object leads to more and more visible scratches on a surface of the glass cover plate, which affects aesthetics of the electronic device. The scratches may further destroy stress balance of the cover plate 11, resulting in decrease of impact resistance of the cover plate 11.

Therefore, to improve scratch resistance, the cover plate 11 further includes a protective structure, and the protective structure is located on a side of the glass substrate that faces away from the display panel 12 (that is, an exposed side), to improve the scratch resistance of the cover plate 11.

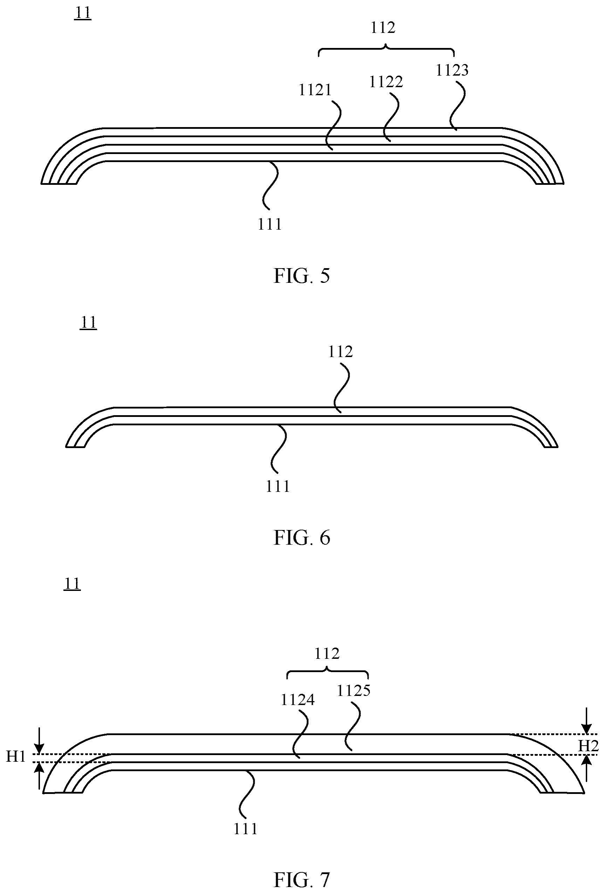

For example, refer to FIG. 5. FIG. 5 is a schematic diagram of a cross-sectional structure of a cover plate of the electronic device shown in FIG. 4 according to an embodiment of this application, which is taken along line AA'. As shown in FIG. 5, the cover plate 11 includes a glass substrate 111 and a protective structure 112 located on a side of the glass substrate. The protective structure 112 is composed of a lower optical layer 1121, a scratch-resistant layer 1122, and an upper optical layer 1123. The lower optical layer 1121 and the upper optical layer 1123 each are formed by alternately stacking high refractive index materials and low refractive index materials to modulate a reflectivity of the protective structure 112 to visible light and improve optical performance. The scratch-resistant layer 1122 is composed of a high-hardness high refractive index material, which can improve scratch resistance of the cover plate 11.

Based on interference caused by a diffraction principle of an optical film layer to light in different bands, a thickness of optical thin film determines an appearance color of the cover plate. The above-mentioned optical film layers (that is, the lower optical layer 1121, the scratch-resistant layer 1122, and the upper optical layer 1123) are formed through coating by a deposition process. During coating, the cover plate is mounted in such a manner that when a normal of a large surface (straight part 111) forms an angle of 0° with an incident angle of coated particles, a maximum deposition rate is obtained, and when a normal of a 3D cambered surface (the first curved part and/or the second curved part) forms a certain angle $\alpha$ with an incident direction of the coated particles, a film layer thickness varies with $\alpha$ in a $\cos\alpha$ relationship. That is, the thickness of the straight part of the cover plate 11 is different from those of the protective structure corresponding to the first curved part and/or the second curved part of the cover plate 11. This leads to color inconsistency between the large surface and the 3D cambered surface and affects an appearance of the mobile phone.

For another example, refer to FIG. 6. FIG. 6 is a schematic diagram of a structure of another cover plate of the electronic device shown in FIG. 4 according to an embodiment of this application, which is taken along line AA'. As shown in FIG. 6, the cover plate 11 includes a glass substrate 111 and a protective structure 112 located on a side of the glass substrate 111. The protective structure 112 is, for example, a single diamond-like carbon (Diamond-Like Carbon, DLC) film layer. The DLC film layer has high hardness, which can improve the scratch resistance of the cover plate 11.

Although the DLC film layer does not cause the problem of color inconsistency between the large surface and the 3D cambered surface, the DLC film layer contains black graphite molecules, and the black graphite molecules have a strong light absorption ability and affect optical performance of the cover plate. In addition, due to the thin DLC film layer (with a thickness not exceeding 50 nm), the DLC film layer is easily subjected to puncture, so there is no significant improvement in the scratch resistance of the cover plate.

That is, the above-mentioned cover plate (including the glass substrate and the protective structure on the glass substrate) cannot take the characteristics of good appearance and optical performance and high scratch resistance into account at the same time.

Based on this, an embodiment of this application provides a housing structure. The housing structure includes a substrate and a protective structure located on a side of the substrate, where the protective structure includes a scratch-resistant layer. The scratch-resistant layer is formed by mixing at least two materials. The at least two materials include at least one high refractive index material and at least one low refractive index material. A refractive index of the scratch-resistant layer formed by mixing the at least one high refractive index material and the at least one low refractive index material is the same as or close to that of the substrate. In this way, the protective structure has no impact on a light transmittance and a light reflectance of the substrate, so that color inconsistency of the cover plate caused by a thin edge area of the protective structure can be avoided. In addition, since the high refractive index material included in the scratch-resistant layer is dense and has a thickness ranging from 300 nm to 5000 nm, the scratch-resistant layer has high scratch resistance. To sum up, the housing structure according to the embodiment of this application has a good appearance and optical performance, and has high scratch resistance.

It should be noted that, the housing structure may be the cover plate 11 in the display module 10, or a rear cover 20 of a mobile phone, a tablet computer, or the like. Of course, application scenarios of the housing structure are not limited to this, as long as the structure is adopted to improve the scratch resistance, optical performance, and the like of the electronic device, which falls within the protection scope of this application.

A specific structure of the housing structure and a preparation process thereof are described in detail below. To describe the subsequent solutions more conveniently and clearly, the following examples are described with an example in which the housing structure is the cover plate 11 of the mobile phone 100, and the following content does not constitute a limitation on this application.

It can be understood that when the housing structure is the rear cover 20 above, the specific structure and effects of the rear cover 20 are the same as those of the following examples in which the housing structure is the cover plate 11, and details of the specific structure and effects when the housing structure is the rear cover 20 are not described below.

The specific structure of the housing structure is first described.

Refer to FIG. 7. FIG. 7 is a schematic diagram of a cross-sectional structure of a housing structure of the electronic device shown in FIG. 4 according to an embodiment of this application, which is taken along line AA'. As shown in FIG. 7, a housing structure 11 includes a substrate 111 and a protective structure 112 located on a side of the substrate 111 that faces away from a display panel 12. The protective structure 112 includes a first underlayer 1124 and a scratch-resistant layer 1125. The first underlayer 1124 is located between the substrate 111 and the scratch-resistant layer 1125, to increase adhesion between the substrate 111 and the scratch-resistant layer 1125, so as to prevent a film layer from falling off to cause a poor appearance, and improve a yield of a hard coating section.

The substrate 111 may include an inorganic glass system substrate such as microcrystalline glass, soda-lime glass, or aluminosilicate glass, or may include an organic substrate such as a polymethyl methacrylate (Polymethyl methacrylate, PMMA) or polycarbonate (Polycarbonate, PC), or may include a ceramic substrate.

Correspondingly, a material of the first underlayer 1124 includes a material such as silicon dioxide, aluminum oxide, or zirconium dioxide, which is homogeneous to the material of the substrate 111 (the same as a material element of the substrate 111) or similar thereto (in the same family or adjacent to the material element of the substrate 111). For example, when the material of the substrate 111 is inorganic glass, since the inorganic glass contains silicon dioxide, the material of the first underlayer 1124 may be, for example, silicon dioxide. When the material of the substrate 111 is sapphire, since the sapphire contains aluminum oxide, the material of the first underlayer 1124 may be, for example, aluminum oxide. In this way, the substrate 111 and the first underlayer 1124 can be better combined.

In this case, a thickness H1 of the first underlayer 1124 may be, for example, greater than or equal to 5 nm and less than or equal to 200 nm. In this way, it is prevented that the adhesion between the substrate 111 and the scratch-resistant layer 1125 is not increased because the first underlayer 1124 is too thin, and that the first underlayer 1124 shows its own performance because the first underlayer 1124 is too thick. For example, if the first underlayer 1124 is too thick, brittle performance of the first underlayer 1124 is shown, which is not conducive to scratch resistance. In the following example, the second underlayer has the same thickness, and details are not described in the following example.

In some embodiments, the thickness H1 of the first underlayer 1124 may be, for example, greater than or equal to 30 nm and less than or equal to 60 nm. For example, the thickness H1 of the first underlayer 1124 may be, for example, 30 nm, 35 nm, 40 nm, 45 nm, 50 nm, 55 nm, or 60 nm.

The scratch-resistant layer 1125 is a film layer formed by mixing at least two materials, and the at least two materials include at least one high refractive index material and at least one low refractive index material. In this application, it is defined that a refractive index of the high refractive index material is generally greater than 1.6, while a refractive index of the low refractive index material is generally less than or equal to 1.52. The high refractive index material in the scratch-resistant layer 1125 can cause the scratch-resistant layer 1125 to have higher hardness and improve scratch resistance of the scratch-resistant layer 1125, while the low refractive index material in the scratch-resistant layer 1125 can cause the overall refractive index of the scratch-resistant layer 1125 to be the same as or similar to that of the substrate 111. When the overall refractive index of the scratch-resistant layer 1125 is the same as or similar to that of the substrate 111, its effect is equivalent to only increasing the thickness of the substrate 111, and there is little impact on the light transmittance and the light reflectance of the substrate 111. Therefore, even if the first underlayer 1124 and the scratch-resistant layer 1125 are arranged on the substrate 111, and the total thickness of the large surface corresponding to the first underlayer 1124 and the scratch-resistant layer 1125 is different from that of the 3D cambered surface corresponding to the first underlayer 1124 and the scratch-resistant layer 1125, there is no difference in appearance color.

In addition, a thickness H2 of the scratch-resistant layer 1125 may be greater than or equal to 300 nm and less than or equal to 5000 nm, so that the problem that the film layer is easily subjected to puncture due to the thin scratch-resistant layer 1125 can be avoided, and the scratch resistance of the scratch-resistant layer is further improved.

The high refractive index material may include, for example, silicon nitride, aluminum oxide, titanium nitride, tantalum oxide, or zirconia, and the low refractive index material may include, for example, silicon dioxide, magnesium fluoride, or calcium fluoride. Of course, the high refractive index material and the low refractive index material are not limited to the types listed above, and may be chosen by a person skilled in the art based on an actual situation, as long as the scratch-resistant layer 1125 includes at least two materials, and the at least two materials include at least one high refractive index material and at least one low refractive index material. This falls within the protection scope of this application.

In some embodiments, a refractive index of the scratch-resistant layer 1125 satisfies the following formulas:

$$R0 \le 100\% - R1 - T1 \qquad (1),$$

and

$$R0 = \left[ \frac{n0 - n1^2/n2}{n0 + n1^2/n2} \right]^2 \qquad (2).$$

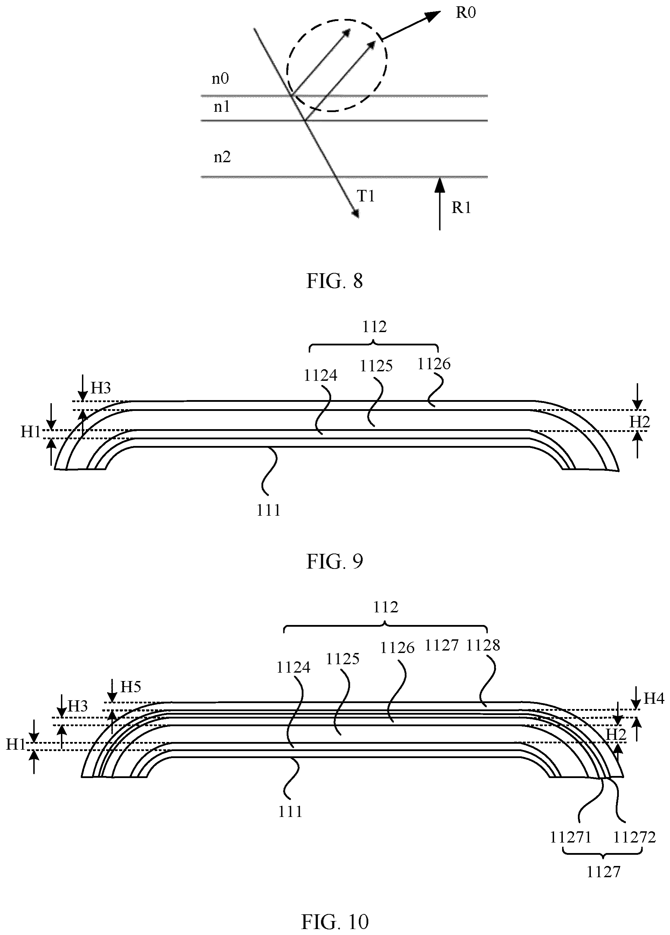

With reference to FIG. 8, FIG. 8 is a schematic diagram of optical reflection of a scratch-resistant layer. As shown in FIG. 8, R0 is a reflectivity of the scratch-resistant layer; R1 is a reflectivity of the substrate; T1 is a transmittance of the housing structure; n0 is a refractive index 1 of air; n1 is the refractive index of the scratch-resistant layer; and n2 is a refractive index of the substrate.

This is because a sum of a transmittance and a reflectivity of the housing structure 11 is 100%. A transmittance of the mobile phone cover plate needs to meet certain requirements. For example, the transmittance of the cover plate of the mobile phone is required to be greater than or equal to 90.5%. The reflectivity is determined by the reflectivity of the substrate and the reflectivity of the scratch-resistant layer. When the material of the substrate is determined, the reflectivity of the substrate is also determined. For example, if the substrate is a glass substrate, the reflectivity of the glass substrate is 4.2. Therefore, the reflectivity of the scratch-resistant layer 1125 needs to satisfy formula (1), that is, the reflectivity R0 of the scratch-resistant layer can be determined based on formula (1). When the reflectivity of the scratch-resistant layer is known, a value of the refractive index of the scratch-resistant layer can be determined based on formula (2).

For example, the substrate 111 is a glass substrate. The reflectivity R1 of the glass substrate is 4.2%, the refractive index n2 of the glass substrate is 1.52, the transmittance T1 of the cover plate of the mobile phone is required to be greater than or equal to 90.5%, and n0 is 1. These are substituted into formula (1) and formula (2) to obtain that the refractive index n1 of the scratch-resistant layer is less than or equal to 1.56.

When the refractive index n1 of the scratch-resistant layer is less than or equal to 1.56, it can be ensured that the transmittance of the housing structure is 90% or above, so that the film layer has no impact on the light transmittance and the light reflectance of the substrate 111.

In this case, based on a Lorentz-Lorenz dispersion theory formula for a multi-material mixed refractive index and an ingredient proportion of a thin film, the refractive index n1 of the scratch-resistant layer after mixing of multiple materials satisfies the following formula:

$$n1^2 = \sum_{i=1}^{N} \left( \frac{a_i n_i^2 c_i}{\rho_i} \right) \Big/ \sum_{i=1}^{N} \left( \frac{a_i c_i}{\rho_i} \right) \qquad (3),$$

where $a_i = (n_i^2 + 2)^{-1}$, $\rho_i$ is a material density, Ci is a material percentage concentration (that is, mass fraction), and $n_i$ is a material refractive index. A mass proportion of a high refractive index and a mass proportion of a low refractive index can be determined based on formula (3). That is, a scratch-resistant layer with a refractive index of 1.56 or below can be obtained by mixing the high refractive index material and the low refractive index material with the mass proportions obtained based on formula (3), so that the scratch-resistant layer 1125 has no impact on the light transmittance and the light reflectance of the substrate 111.

For example, the scratch-resistant layer 1125 is formed by mixing high refractive index material aluminum oxide ($Al_2O_3$) and low refractive index material silicon dioxide ($SiO_2$), or the scratch-resistant layer 1125 is formed by mixing high refractive index material silicon nitride ($Si_3N_4$) and low refractive index material silicon dioxide ($SiO_2$), where the high refractive index material has a percentage weight concentration of $C_H$, a density of $\rho_H$, and a refractive index of $n_H$; and the low refractive index material has a percentage weight concentration of $C_L$, a density of $\rho_L$, and a refractive index of $n_L$. The percentage weight concentration $C_H$, the density $\rho_H$, and the refractive index $n_H$ of the high refractive index material, and the percentage weight concentration $C_L$ ($C_L = 1 - C_H$), the density $\rho_L$, and the refractive index $n_L$ of the low refractive index material are substituted into formula (3), and then formula (3) can be simplified to obtain:

$$n1^2 = \frac{\frac{n_L^2}{\rho_L}\left(\frac{1}{c_H} - 1\right) + \frac{n_H^2}{\rho_H}\frac{a_H}{a_L}}{\frac{1}{\rho_L}\left(\frac{1}{c_H} - 1\right) + \frac{1}{\rho_H}\frac{a_H}{a_L}} \qquad (4).$$

Calculation results are shown in Table 1 below.

Table 1 shows a relationship between the mass fraction of the high refractive index material, the refractive index of the scratch-resistant layer, and the transmittance of the housing structure.

| Performance requirement | Optical index requirement | Mass percentage of the high refractive index material | Mixed refractive index | |
|---|---|---|---|---|
| | | | $SiO_2$-$Al_2O_3$ | $SiO_2$-$Si_3N_4$ |
| | | 0.10 | 1.47 | 1.49 |

(continued)

| Performance requirement | Optical index requirement | Mass percentage of the high refractive index material | Mixed refractive index | |
|---|---|---|---|---|
| | | | SiO$_2$-Al$_2$O$_3$ | SiO$_2$-Si$_3$N$_4$ |
| Transmittance of the cover plate ≥ 90.5% | Refractive index of the scratch-resistant layer ≤ 1.56 | 0.20 | 1.49 | 1.52 |
| | | 0.30 | 1.50 | 1.56 |
| | | 0.40 | 1.52 | 1.61 |
| | | 0.50 | 1.54 | 1.66 |
| | | 0.60 | 1.56 | 1.71 |
| | | 0.70 | 1.59 | 1.78 |
| | | 0.80 | 1.62 | 1.85 |
| | | 0.90 | 1.65 | 1.95 |
| | | 1.00 | 1.70 | 2.06 |

It can be seen from Table 1 that when the scratch-resistant layer 1125 is formed by mixing two materials, namely, the high refractive index material aluminum oxide (Al$_2$O$_3$) and the low refractive index material silicon dioxide (SiO$_2$), and the mass fraction of the high refractive index material aluminum oxide (Al$_2$O$_3$) is less than or equal to 60%, the refractive index of the scratch-resistant layer is less than or equal to 1.56. When the scratch-resistant layer 1125 is formed by mixing two materials, namely, the high refractive index material silicon nitride (Si$_3$N$_4$) and the low refractive index material silicon dioxide (SiO$_2$), and the mass fraction of the high refractive index material silicon nitride (Si$_3$N$_4$) is less than or equal to 30%, the refractive index of the scratch-resistant layer is less than or equal to 1.56.

In addition, to solve the problem that the Young's modulus of the scratch-resistant layer 1125 is too large, which leads to an excessive stress of the film layer, causing deformation of a base material (substrate 111) and the decrease of the adhesion of the film layer (scratch-resistant layer 1125), the Young's modulus of the scratch-resistant layer 1125 needs to be greater than that of the substrate 111, and a relationship therebetween is $1 \leq E1 / E3 \leq 3$, where E1 is the Young's modulus of the scratch-resistant layer 1125 and E3 is Young's modulus of the substrate 111. That is, the Young's modulus of the scratch-resistant layer 1125 is 1-3 times that of the substrate 111.

To further adjust the appearance color of the housing structure, refer to FIG. 9. FIG. 9 is a film layer diagram of another housing structure according to an embodiment of this application. As shown in FIG. 9, the protective structure 112 further includes an optical adjustment layer 1126 located on a side of the scratch-resistant layer 1125 that faces away from the first underlayer 1124 and configured to adjust optical performance and the appearance color of the housing structure.

A material of the optical adjustment layer 1126 is not limited in the embodiment of this application, and may be chosen by a person skilled in the art based on an actual situation. The optical adjustment layer 1126 may be composed of one material or a plurality of materials. For example, when the optical adjustment layer 1126 is composed of one material, the material of the optical adjustment layer 1126 may be, for example, one of silicon dioxide, titanium dioxide, tantalum pentoxide, niobium pentoxide, and the like, or when the optical adjustment layer 1126 is composed of a plurality of materials, the materials of the optical adjustment layer 1126 may be, for example, at least two of silicon dioxide, titanium dioxide, tantalum pentoxide, niobium pentoxide, and the like.

The thickness of the optical adjustment layer 1126 may be designed by a person skilled in the art based on the thickness of the scratch-resistant layer 1125, the refractive index of the scratch-resistant layer 1125, the refractive index of the optical adjustment layer 1126, and color requirements for the optical adjustment layer 1126 (for example, the color requirement for the optical adjustment layer 1126 is that values a and b are ± 1) based on optical design software (such as optical thin film design software TFC and optical thin film analysis software Macleod).

The values a and b are values a and b in a Lab chromaticity system, where a component L in the Lab chromaticity system is used to denote brightness of a pixel, with a value range of [0, 100], representing a range from pure black to pure white; a represents a range from red to green, with a value range being [127, -128]; and b represents a range from yellow to blue, with a value range being [127, -128].

For example, the range of the thickness H3 of the optical adjustment layer 1126 may be less than or equal to 300 nm. In some embodiments, the thickness H3 of the optical adjustment layer 1126 may be greater than or equal to 60 nm and less than or equal to 80 nm. For example, the thickness H3 of the optical adjustment layer 1126 may be 60 nm, 65 nm, 70 nm, 75 nm, 80 nm, or the like.

To reduce damage of external friction with a hard object to the housing structure, refer to FIG. 10. FIG. 10 is a schematic diagram of a cross-sectional structure of another housing structure of the electronic device shown in FIG. 4 according to an embodiment of this application, which is taken along line AA'. As shown in FIG. 10, the protective structure 112 further includes a second underlayer 1127 and an antifriction layer 1128. The second underlayer 1127 is located between the optical adjustment layer 1126 and the antifriction layer 1128 to increase adhesion between the antifriction layer 1128 and the optical adjustment layer 1126, and further improve alkali sweat resistance of the antifriction layer 1128.

For example, the second underlayer 1127 may include, for example, two film layers, namely, a first sub-underlayer 11271 and a second sub-underlayer 11272, where the second sub-underlayer 11272 is located on a side of the first sub-underlayer 11271 that faces away from the optical adjustment layer 1126. The second sub-underlayer 11272 may be composed of, for example, $SiO_2$, SiO, or a material doped with $SiO_2$, and a range of the thickness (in the Z-axis direction) of the second sub-underlayer 11272 is generally less than or equal to 50 nm. For example, the thickness of the second sub-underlayer 11272 may be 10 nm, 15 nm, 20 nm, 25 nm, 30 nm, 35 nm, 40 nm, 45 nm, 50 nm, or the like. The first sub-underlayer 11271 may be composed of, for example, one or more materials with Mohs hardness greater than 7. The material with Mohs hardness greater than 7 may include, for example, diamond-like carbon, diamond, or carbon nitride. The range of the thickness (in the Z-axis direction) of the first sub-underlayer 11271 may be less than or equal to 200 nm, that is, a range of a thickness H4 of the second underlayer 1127 may be less than or equal to 250 nm. For example, the thickness of the first sub-underlayer 11271 may be 10 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, or 200 nm.

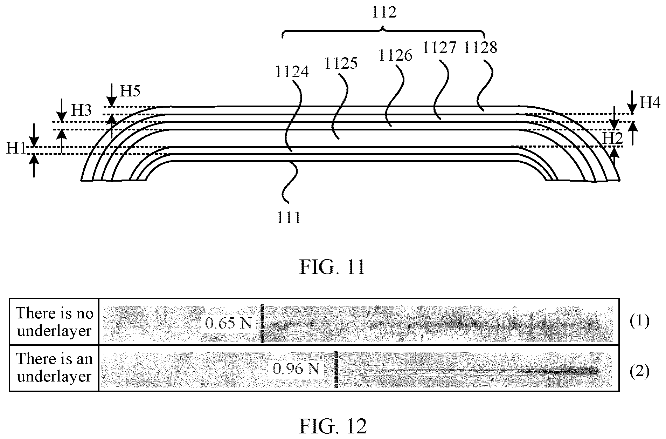

Of course, the second underlayer 1127 is not limited to the case of including two film layers. Referring to FIG. 11, the second underlayer 1127 may alternatively include one film layer.

A dynamic friction coefficient of the antifriction layer 1128 may be, for example, greater than or equal to 0.01 and less than or equal to 0.1, and a contact angle is greater than, for example, 100°. In addition, due to a small frictional force, there is a smoother touch and it is less likely to leave a mark. Therefore, the antifriction layer 1128 further has an anti-fingerprint (Anti-fingerprint, AF) function.

This is because when a user touches the display module 10 with a finger, a frictional force is generated between the finger and the cover plate, and the frictional force damages each film layer of the cover plate. A frictional force formula is as follows:

$$f = \mu \times Fn,$$

where f is a frictional force, Fn is a positive pressure, and $\mu$ is a friction coefficient.

Therefore, since the dynamic friction coefficient of the antifriction layer 1128 in the embodiment of this application ranges from 0.01 to 0.1, when touching the display module 10, the user can feel a smooth touch, and user experience is improved.

The material of the antifriction layer 1128 is not limited in the embodiment of this application, as long as the above requirements for the friction coefficient are met. For example, the antifriction layer 1128 may include organic and inorganic materials with low surface energy. For example, the material of the antifriction layer 1128 may be perfluoropolyethers (Perfluoropolyethers, PFPE).

The thickness of the antifriction layer 1128 is not limited in the embodiment of this application, and may be set by a person skilled in the art based on an actual situation. For example, a thickness H5 of the antifriction layer 1128 may be greater than or equal to 3 nm and less than or equal to 50 nm.

To sum up, in the housing structure according to the embodiment of this application, since the scratch-resistant layer 1125 is composed of a mixture of the high refractive index material and the low refractive index material, the refractive index of the film layer ranges from 1.46 to 1.75, and a coating layer with this refractive index has no impact on the light transmittance and light reflectance of the substrate 111. In this way, the film layer has a higher transmittance and a lower reflectivity after coating, and even if the thickness of the large surface is different from that of the 3D cambered surface, there is no appearance color difference. In addition, the Mohs hardness of the housing structure after coating is 7 or above, and puncture resistance of the film layer is enhanced. The optical adjustment layer 1126 can adjust the optical performance of the substrate to meet optical performance requirements. The first underlayer 1124 is arranged between the substrate 111 and the scratch-resistant layer 1125, and the second underlayer 1127 is arranged between the antifriction layer 1128 and the optical adjustment layer 1126, so that a poor appearance caused by falling of the film layer can be avoided, thereby greatly increasing a yield of a hard coating section. That is, the housing structure according to the embodiment of this application has high puncture resistance, a high transmittance, and an appearance with a good touch.

To explain the above effects of the housing structure according to this application in detail, the housing structure according to the embodiment of this application was tested. The testing of the housing structure shown in FIG. 10 is described.

Specifically, adhesion of each film layer in the housing structure shown in FIG. 10 was increased by 20% to 50% according to testing by a micrometer scratch tester. For example, refer to FIG. 12. FIG. 12 is a comparative test diagram of a housing structure according to an embodiment of this application. FIG. 12(1) is a test result diagram when a housing structure 11 according to an embodiment of this application includes neither a first underlayer 1124 nor a second underlayer 1127, and FIG. 12(2) is a test result diagram when a housing structure 11 according to an embodiment of this application includes a first underlayer 1124 and a second underlayer 1127 By comparison, it can be seen that when the housing structure 11 that includes neither the first underlayer 1124 nor the second underlayer 1127 was loaded with a force of 0.65 N, there was a problem of falling of the film layers of the housing structure 11. When the housing structure 11 that includes the first underlayer 1124 and the second underlayer 1127 was loaded with a force of 0.96 N, the film layers of the housing structure 11 did not fall off. That is, adhesion between the film layers of the housing structure 11 according to the embodiment of this application is significantly improved.

The hardness of the housing structure shown in FIG. 10 was measured by a nanoindenter. For example, Vickers hardness obtained was 1000-2600 HV, and the Young's modulus obtained was 80-170 Gpa. A hardness test was performed by a Vickers indenter. An indentation depth measured on a surface of a hard film system was less than or equal to about 100 nm, and the hardness was greater than or equal to about 1100 HV. Surface hardness of the above-mentioned film layers (the first underlayer 1124, the scratch-resistant layer 1125, the optical adjustment layer 1126, the second underlayer 1127, and the antifriction layer 1128) on the substrate 111 was tested by a Mohs hardness pen, and a weight of 500 grams was loaded on the Mohs hardness pen. The Mohs hardness measured was 7 or above. That is, the housing structure 11 according to the embodiment of this application has high hardness, and the film layers have high puncture resistance.

Optical performance of the housing structure 11 was tested by a spectrophotometer, and results obtained were as follows: the housing structure had a reflectivity less than 15% and a transmittance greater than 85% in a light wavelength region in the range of 380-780 nm. That is, the housing structure 11 according to the embodiment of this application has good optical performance.

According to the regulations of the International Commission on Illumination, under a condition of normal incidence, a colorimeter was used for testing in a (L*, a*, b*) chromaticity system to obtain a reflection color value a of $\pm 1$ and a reflection color value b of $\pm 1$, and a transmission color value a of $\pm 1$ and a transmission color value of $\pm 1$. That is, the housing structure 11 according to the embodiment of this application has a good external light color.

To sum up, it can be seen from the test that the housing structure according to the embodiment of this application has high hardness and high puncture resistance, further has a high transmittance and a good appearance, and can greatly improve the yield of the hard coating section.

It should be noted that, the above test was based on an example of a housing structure (the housing structure shown in FIG. 10), aiming to show that the housing structure 11 according to this application has high hardness, high puncture resistance, a high transmittance, a good appearance, and the like, and greatly improves the yield of the hard coating section. Actually, results of Vickers hardness, transmittance, and the like obtained when different housing structures 11 were tested are not limited to the above examples.

The specific structure of the housing structure 11 has been described above, and a process for preparing a housing structure is described below with reference to the housing structure shown in FIG. 11. Since a method for preparing a housing structure can be used for preparing the above housing structure, for example, the method has the same beneficial effects as the housing structure. For details not described in detail in this embodiment, reference may be made to the embodiment of the housing structure.

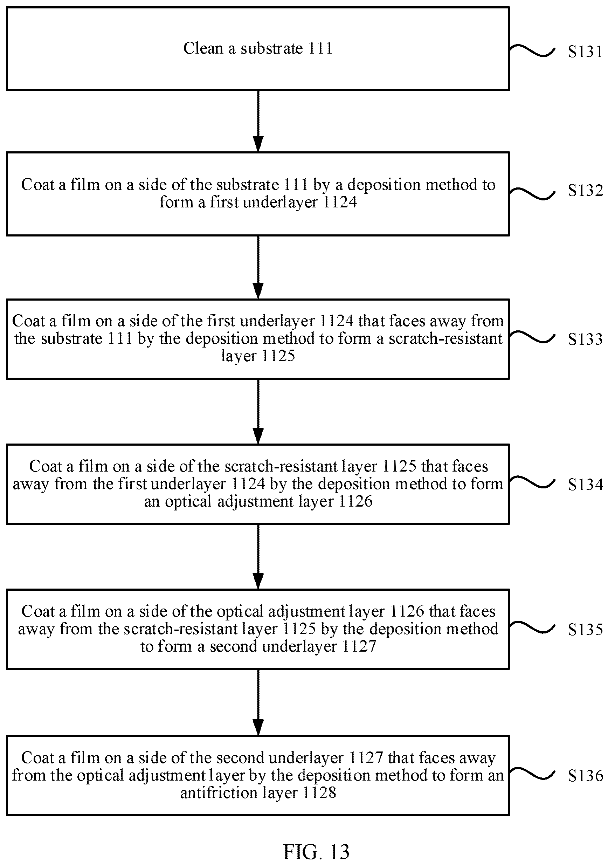

Refer to FIG. 13. FIG. 13 is a flowchart of a method for preparing a housing structure according to an embodiment of this application. As shown in FIG. 13, the method for preparing a housing structure according to the embodiment of this application includes the following specific steps.

S131: Clean a substrate 111.

For example, the substrate is a glass substrate, and a glass base material is placed into a magnetron sputtering machine for argon ion cleaning.

A base pressure is $1 \times 10^{-3}$ Pa. In an experiment, Ar gas is first introduced to 0.5 Pa, and a surface of a sample is cleaned by Ar+ plasma generated by a capacitively coupled plasma source for 10 min to remove pollutants and adsorbed gases on the surface.

S132: Coat a film on a side of the substrate 111 by a deposition method to form a first underlayer 1124.

Specifically, a designed thickness is input into a coating machine, and then process parameters are set: for example, the base pressure is $5.0 \times 10^{-4}$ Pa, and the temperature is set to: 80°C; specific parameters: ion source (radical source): 4500 W; Ar flow rate: 200 sccm; $O_2$ flow rate: 120 sccm; $N_2$ flow rate: 0 sccm; Coating time: 240s, to obtain first underlayer $SiO_2$, with a thickness of 40-80 nm.

S133: Coat a film on a side of the first underlayer 1124 that faces away from the substrate 111 by the deposition method to form a scratch-resistant layer 1125/

The scratch-resistant layer 1125 is composed of, for example, $SiO_2$ (low refractive index material)-$Si_3N_4$ (high refractive index material). It is calculated based on Table 1 that the scratch-resistant layer of $SiO_2$ (low refractive index material)-$Si_3N_4$ (high refractive index material) is designed with a refractive index of 1.6 and a film layer thickness of 2000 nm.

Process parameters are set: for example, the base pressure is $5.0 \times 10^{-4}$ Pa; to obtain SiON ($SiO_2$-$Si_3N_4$) designed above, coating parameters are set as follows: sputtering power of a silicon target: 7500 W; Ar flow rate: 120 sccm; $N_2$ flow rate: 80 sccm; oxygen flow rate: 30 sccm; power of RadicalSource: 4500 W, and required thickness for device input: 2000 nm.

S134: Coat a film on a side of the scratch-resistant layer 1125 that faces away from the first underlayer 1124 by the deposition method to form an optical adjustment layer 1126.

S135: Coat a film on a side of the optical adjustment layer 1126 that faces away from the scratch-resistant layer 1125 by the deposition method to form a second underlayer 1127.

For example, the second underlayer is, for example, a $SiO_2$ underlayer. To obtain the underlayer $SiO_2$, set coating parameters are, for example: sputtering power of a silicon target: 8 KW; Ar flow rate: 200 sccm; $O_2$ flow rate: 120 sccm; Coating time Time: 6-10 min, to obtain a silicon dioxide film layer, with a thickness of 40-80 nm.

S136: Coat a film on a side of the second underlayer 1127 that faces away from the optical adjustment layer 1126 by the deposition method to form an antifriction layer 1128.

Process parameters are set: for example, the base pressure for coating the antifriction layer is $5.0 \times 10^{-3}$ Pa; specific parameters: power: 1-5 KW; coating pressure: $5.0 \times 10^{-2}$ Pa, and coating time: 6 min.

Optionally, to enhance the adhesion between the film layers, the second underlayer 1127 is subjected to anode plasma processing before the antifriction layer 1128 is coated.

The housing structure shown in FIG. 11 can be obtained through the above steps. Then, the housing structure formed by this method was tested to conclude that the housing structure had optical performance, that is, a transmittance of 91. 1% and a reflectivity of 8.4% in a 380-780 nm band. A hardness test was performed by a Vickers indenter. An indentation depth measured on a hard AR surface was less than or equal to about 100 nm, and the hardness was 1280 HV. In a Mohs hardness test, a force of 500 g was reached, the Mohs hardness was greater than 7, with a transmittance color value A of 0.73 and a transmittance color value B of -0.87, and a reflection color value A of -0.34 and a reflection color value B of 0.68. That is, the housing structure according to the embodiment of this application has high hardness and high puncture resistance, and further has a high transmittance and a good appearance.

The process for preparing the housing structure is not limited to this. The process for preparing a housing structure is described below with reference to the housing structure shown in FIG. 10.

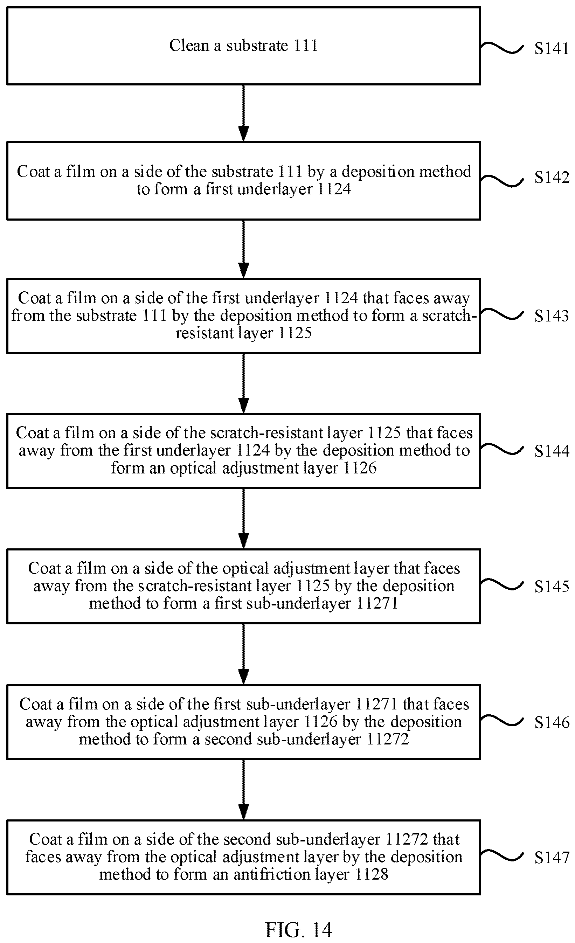

Refer to FIG. 14. FIG. 14 is a flowchart of another method for preparing a housing structure according to an embodiment of this application. As shown in FIG. 14, the method for preparing a housing structure according to the embodiment of this application includes the following specific steps.

S141: Clean a substrate 111.

For example, the substrate is a glass substrate, and a glass base material is placed into a magnetron sputtering machine for argon ion cleaning.

A base pressure is $1 \times 10^{-3}$ Pa. In an experiment, Ar gas is first introduced to 0.5 Pa, and a surface of a sample is cleaned by Ar+ plasma generated by a capacitively coupled plasma source for 10 min to remove pollutants and adsorbed gases on the surface.

S142: Coat a film on a side of the substrate 111 by a deposition method to form a first underlayer 1124.

Specifically, a designed thickness is input into a coating machine, and then process parameters are set: for example, the base pressure is $5.0 \times 10^{-4}$ Pa, and the temperature is set to: 80°C; specific parameters: ion source (radical source): 4500 W; Ar flow rate: 200 sccm; $O_2$ flow rate: 120 sccm; $N_2$ flow rate: 0 sccm; Coating time: 240s, to obtain first underlayer $SiO_2$, with a thickness of 40-80 nm.

S143: Coat a film on a side of the first underlayer 1124 that faces away from the substrate 111 by the deposition method to form a scratch-resistant layer 1125/

The scratch-resistant layer 1125 is composed of, for example, $SiO_2$ (low refractive index material)-$Si_3N_4$ (high refractive index material). It is calculated based on Table 1 that the scratch-resistant layer of $SiO_2$ (low refractive index material)-$Si_3N_4$ (high refractive index material) is designed with a refractive index of 1.75 and a film layer thickness of 1500 nm.

Process parameters are set: for example, the base pressure is $5.0 \times 10^{-4}$ Pa; to obtain SiON ($SiO_2$-$Si_3N_4$) designed above, coating parameters are set as follows: sputtering power of a silicon target: 7500 W; Ar flow rate: 120 sccm; $N_2$ flow rate: 80 sccm; oxygen flow rate: 20 sccm; power of RadicalSource: 4500 W, and required thickness for device input: 1500 nm.

S144: Coat a film on a side of the scratch-resistant layer 1125 that faces away from the first underlayer 1124 by the deposition method to form an optical adjustment layer 1126.

A material of the optical adjustment layer 1126 is, for example, silicon dioxide. To obtain the optical adjustment

layer SiO$_2$, set coating parameters: sputtering power of a silicon target: 8 KW, Ar flow rate: 200 sccm, O$_2$ flow rate: 120 sccm, and coating time: 6-10 min, to obtain a silicon dioxide film layer with a thickness of 40-80 nm.

S145: Coat a film on a side of the optical adjustment layer 1126 that faces away from the scratch-resistant layer by the deposition method to form a first sub-underlayer 11271.

For example, to obtain an underlayer hard film CN, set coating parameters: sputtering power of a C target: 8 KW, Ar flow rate: 250 sccm, N$_2$ flow rate: 120 sccm, and coating time: 5 min, to obtain a CN film layer with a thickness of 5-20 nm.

S146: Coat a film on a side of the first sub-underlayer 11271 that faces away from the optical adjustment layer 1126 by the deposition method to form a second sub-underlayer 11272. For example, to obtain the underlayer SiO$_2$, set coating parameters: sputtering power of a silicon target: 8 KW, Ar flow rate: 200 sccm, O$_2$ flow rate: 120 sccm, and coating time: 2 min, to obtain a silicon dioxide film layer with a thickness of 3-20 nm.

S147: Coat a film on a side of the second sub-underlayer 11272 that faces away from the optical adjustment layer by the deposition method to form an antifriction layer 1128.

Process parameters are set: for example, the base pressure for coating the antifriction layer is 5.0 $\times$ 10$^{-3}$ Pa; specific parameters: power: 1-5 KW; coating pressure: 5.0 $\times$ 10$^{-2}$ Pa, and coating time: 6 min.

Optionally, to enhance the adhesion between the film layers, the second underlayer 1127 is subjected to anode plasma processing before the antifriction layer 1128 is coated.

The housing structure shown in FIG. 10 can be obtained through the above steps. Then, the housing structure formed by this method was tested to conclude that the housing structure had optical performance, that is, a transmittance, of 92.4% and a reflectivity of 7.4% in a 380-780 nm band. A hardness test was performed by a Vickers indenter, an indentation depth measured on a hard AR surface was less than or equal to about 100 nm, and the hardness was 1580 HV. In a Mohs hardness test, a force of 1500 g was reached, the Mohs hardness was greater than 7, with a transmittance color value A of 0.02 and a transmittance color value B of -0.07, and a reflection color value A of 0.43 and a reflection color value B of 0.57. That is, the housing structure according to the embodiment of this application has high hardness and high puncture resistance, and further has a high transmittance and a good appearance.

It should be noted that, various deposition methods can be used in the above-mentioned film layer coating manufacturing manners. For example, vacuum deposition techniques, such as chemical vapor deposition (such as plasma enhanced chemical vapor deposition (PECVD), low pressure chemical vapor deposition, atmospheric pressure chemical vapor deposition, and plasma enhanced atmospheric pressure chemical vapor deposition), physical vapor deposition (such as reactive or non-reactive sputtering or laser ablation), thermal or electron beam evaporation or atomic layer deposition, are used to form each film layer. Liquid-based methods such as spray coating, dip coating, spin coating or slit coating (for example, using sol-gel materials) may alternatively be used.

As mentioned above, the foregoing embodiments are merely used for illustrating rather than limiting the technical solutions of this application. Although this application has been illustrated in detail with reference to the foregoing embodiments, it should be understood by a person of ordinary skill in the art that the technical solutions described in the foregoing embodiments may still be modified, or some of the technical features therein may be equivalently substituted, but these modifications or substitutions do not make the essence of corresponding technical solutions depart from the scope of the technical solutions of the embodiments of this application.

**Claims**

1. A housing structure, comprising:

   a substrate and a scratch-resistant layer located on a side of the substrate, wherein
   the scratch-resistant layer comprises at least two materials, and the at least two materials comprise at least one high refractive index material and at least one low refractive index material; and
   the scratch-resistant layer has a thickness greater than or equal to 300 nm and less than or equal to 5000 nm, wherein the low refractive index material has a refractive index less than or equal to a refractive index of the substrate, and the high refractive index material has a refractive index greater than 1.6.

2. The housing structure according to claim 1, further comprising a first underlayer located between the substrate and the scratch-resistant layer, and configured to improve adhesion between the substrate and the scratch-resistant layer.

3. The housing structure according to claim 2, wherein a material of the first underlayer is the same as a material element of the substrate, or is in the same family as or adjacent to the material element of the substrate.

4. The housing structure according to claim 2, wherein the first underlayer has a thickness greater than or equal to 5 nm and less than or equal to 200 nm.

5. The housing structure according to any one of claims 1 to 4, further comprising an optical adjustment layer located on a side of the scratch-resistant layer that faces away from the substrate, and configured to adjust an appearance color of the housing structure.

6. The housing structure according to claim 5, wherein the optical adjustment layer has a thickness less than or equal to 300 nm.

7. The housing structure according to claim 5, wherein a material of the optical adjustment layer comprises at least one of silicon dioxide, titanium dioxide, tantalum pentoxide, and niobium pentoxide.

8. The housing structure according to any one of claims 1 to 7, further comprising an antifriction layer located on a side of the scratch-resistant layer that faces away from the substrate.

9. The housing structure according to claim 8, wherein the antifriction layer has a dynamic friction coefficient greater than or equal to 0.01 and less than or equal to 0.1, and a contact angle greater than 100°.

10. The housing structure according to claim 8, wherein the antifriction layer has a thickness greater than or equal to 3 nm and less than or equal to 50 nm.

11. The housing structure according to claim 8, wherein the antifriction layer is composed of an organic material and an inorganic material that have low surface energy.

12. The housing structure according to claim 8, further comprising a second underlayer located between the antifriction layer and the scratch-resistant layer, and configured to improve adhesion of the antifriction layer.

13. The housing structure according to claim 12, wherein the second underlayer comprises a first sub-underlayer and a second sub-underlayer, and the second sub-underlayer is located on a side of the first sub-underlayer that faces away from the scratch-resistant layer.

14. The housing structure according to claim 13, wherein the first sub-underlayer has a thickness less than or equal to 200 nm; and the second sub-underlayer has a thickness less than or equal to 50 nm.

15. The housing structure according to claim 13, wherein a material of the second sub-underlayer comprises silicon monoxide, silicon dioxide, or a material doped with silicon dioxide; and a material of the first sub-underlayer comprises diamond-like carbon, diamond, or carbon nitride.

16. The housing structure according to claim 1, wherein a refractive index of the scratch-resistant layer satisfies the following formulas:

$$R0 \le 100\% - R1 - T1,$$

$$R0 = \left[ \frac{n0 - n1^2/n2}{n0 + n1^2/n2} \right]^2$$

wherein R0 is a reflectivity of the scratch-resistant layer; R1 is a reflectivity of the substrate; T1 is a transmittance of the housing structure; n0 is a refractive index 1 of air; n1 is the refractive index of the scratch-resistant layer; and n2 is a refractive index of the substrate.

17. The housing structure according to claim 16, wherein mass fractions of the high refractive index material and the low refractive index material satisfy:

$$n1^2 = \sum_{i=1}^{N} \left( \frac{a_i\, n_i^2\, c_i}{\rho_i} \right) \Big/ \sum_{i=1}^{N} \left( \frac{a_i\, c_i}{\rho_i} \right)$$

wherein $a_i = (n_i^2 + 2)^{-1}$, $\rho_i$ is a material density, Ci is a material mass fraction, and $n_i$ is a material refractive index.

18. The housing structure according to claim 17, wherein the scratch-resistant layer is formed by mixing aluminum oxide and silicon dioxide, the aluminum oxide has a mass fraction less than or equal to 80%, and the scratch-resistant layer has a refractive index less than or equal to 1.7.

19. The housing structure according to claim 17, wherein the scratch-resistant layer is formed by mixing silicon nitride and silicon dioxide, the silicon nitride has a mass fraction less than or equal to 60%, and the scratch-resistant layer has a refractive index less than or equal to 1.7.

20. The housing structure according to claim 1, wherein the scratch-resistant layer is formed by a deposition process.

21. A display module, comprising the housing structure according to any one of claims 1 to 20.

22. An electronic device, comprising the housing structure according to any one of claims 1 to 20.

23. The electronic device according to claim 22, comprising a display module, wherein the display module comprises a display panel and a cover plate located on a side of the display panel, and the housing structure is the cover plate of the electronic device.

24. The electronic device according to claim 22, comprising a rear cover, wherein the housing structure is the rear cover of the electronic device.

FIG. 1

FIG. 2

FIG. 3

FIG. 4

FIG. 5

FIG. 6

FIG. 7

FIG. 8

FIG. 9

FIG. 10

FIG. 11

| There is no underlayer | 0.65 N | (1) |
| There is an underlayer | 0.96 N | (2) |

FIG. 12

Clean a substrate 111 — S131

↓

Coat a film on a side of the substrate 111 by a deposition method to form a first underlayer 1124 — S132

↓

Coat a film on a side of the first underlayer 1124 that faces away from the substrate 111 by the deposition method to form a scratch-resistant layer 1125 — S133

↓

Coat a film on a side of the scratch-resistant layer 1125 that faces away from the first underlayer 1124 by the deposition method to form an optical adjustment layer 1126 — S134

↓

Coat a film on a side of the optical adjustment layer 1126 that faces away from the scratch-resistant layer 1125 by the deposition method to form a second underlayer 1127 — S135

↓

Coat a film on a side of the second underlayer 1127 that faces away from the optical adjustment layer by the deposition method to form an antifriction layer 1128 — S136

FIG. 13

Clean a substrate 111 ~ S141

Coat a film on a side of the substrate 111 by a deposition method to form a first underlayer 1124 ~ S142

Coat a film on a side of the first underlayer 1124 that faces away from the substrate 111 by the deposition method to form a scratch-resistant layer 1125 ~ S143

Coat a film on a side of the scratch-resistant layer 1125 that faces away from the first underlayer 1124 by the deposition method to form an optical adjustment layer 1126 ~ S144

Coat a film on a side of the optical adjustment layer that faces away from the scratch-resistant layer 1125 by the deposition method to form a first sub-underlayer 11271 ~ S145

Coat a film on a side of the first sub-underlayer 11271 that faces away from the optical adjustment layer 1126 by the deposition method to form a second sub-underlayer 11272 ~ S146

Coat a film on a side of the second sub-underlayer 11272 that faces away from the optical adjustment layer by the deposition method to form an antifriction layer 1128 ~ S147

FIG. 14

## INTERNATIONAL SEARCH REPORT

International application No.

**PCT/CN2023/132665**

| A. | CLASSIFICATION OF SUBJECT MATTER |
|---|---|

H05K 5/02(2006.01)i

According to International Patent Classification (IPC) or to both national classification and IPC

| B. | FIELDS SEARCHED |
|---|---|

Minimum documentation searched (classification system followed by classification symbols)

IPC:H05K

Documentation searched other than minimum documentation to the extent that such documents are included in the fields searched

Electronic data base consulted during the international search (name of data base and, where practicable, search terms used)

CNABS; CNTXT; VEN; USTXT; EPTXT; ENTXTC; WOTXT; CNKI: 壳, 抗划伤, 抗划痕, 高, 低, 折射率, 反射率, 厚度, 蓝宝石, 基板, 玻璃, 显示屏, 屏幕, cover, plate, layer, low, high, refractive, index , screen, display

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 114745463 A (GUANGDONG OPPO MOBILE TELECOMMUNICATIONS CORP., LTD.) 12 July 2022 (2022-07-12)<br>description, paragraphs [0002]-[0069] | 1-24 |
| X | CN 111087177 A (SUZHOU VICTORY PRECISION MANUFACTURING TECHNOLOGY CO., LTD.) 01 May 2020 (2020-05-01)<br>description, paragraphs [0002]-[0042] | 1-24 |
| A | CN 107311472 A (YICHANG NANBO DISPLAY CO., LTD.) 03 November 2017 (2017-11-03)<br>entire document | 1-24 |
| A | CN 114025545 A (GUANGDONG OPPO MOBILE TELECOMMUNICATIONS CORP., LTD.) 08 February 2022 (2022-02-08)<br>entire document | 1-24 |
| A | CN 115050904 A (HONOR DEVICE CO., LTD.) 13 September 2022 (2022-09-13)<br>entire document | 1-24 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 January 2024** | **07 March 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| | International application No. |
|---|---|
| | PCT/CN2023/132665 |

| Patent document cited in search report | | | Publication date (day/month/year) | Patent family member(s) | Publication date (day/month/year) |
|---|---|---|---|---|---|
| CN | 114745463 | A | 12 July 2022 | None | |
| CN | 111087177 | A | 01 May 2020 | None | |
| CN | 107311472 | A | 03 November 2017 | None | |
| CN | 114025545 | A | 08 February 2022 | None | |
| CN | 115050904 | A | 13 September 2022 | None | |

Form PCT/ISA/210 (patent family annex) (July 2022)

**EP 4 669 038 A1**

## REFERENCES CITED IN THE DESCRIPTION

**Patent documents cited in the description**

- CN 202310278159